(19) Europäisches Patentamt
European Patent Office
Office européen des brevets

(11) **EP 2 219 225 B1**

(12) **EUROPEAN PATENT SPECIFICATION**

(45) Date of publication and mention
of the grant of the patent:
**20.06.2012 Bulletin 2012/25**

(51) Int Cl.:
*H01L 29/786* (2006.01)    *H01L 29/26* (2006.01)
*H01L 21/02* (2006.01)    *C23C 14/08* (2006.01)
*C23C 14/34* (2006.01)

(21) Application number: **08850158.0**

(22) Date of filing: **12.11.2008**

(86) International application number:
**PCT/JP2008/070963**

(87) International publication number:
**WO 2009/064007 (22.05.2009 Gazette 2009/21)**

(54) **OXIDE SEMICONDUCTOR MATERIAL, METHOD FOR MANUFACTURING OXIDE SEMICONDUCTOR MATERIAL, ELECTRONIC DEVICE AND FIELD EFFECT TRANSISTOR**

OXID-HALBLEITERMATERIAL, VERFAHREN ZUR HERSTELLUNG EINES OXID-HALBLEITERMATERIALS, ELEKTRONISCHE ANORDNUNG UND FELDEFFEKTTRANSISTOR

MATÉRIAU EN OXYDE SEMI-CONDUCTEUR, PROCÉDÉ DE FABRICATION D'UN MATÉRIAU EN OXYDE SEMI-CONDUCTEUR, DISPOSITIF ÉLECTRONIQUE ET TRANSISTOR À EFFET DE CHAMP

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **15.11.2007 JP 2007296984**

(43) Date of publication of application:
**18.08.2010 Bulletin 2010/33**

(73) Proprietor: **Sumitomo Chemical Company, Limited**
**Tokyo 104-8260 (JP)**

(72) Inventors:
• **HASEGAWA, Akira**
**Tsukuba-shi**
**Ibaraki 305-0821 (JP)**
• **KOHIRO, Kenji**
**Tsukuba-shi**
**Ibaraki 305-0032 (JP)**
• **FUKUHARA, Noboru**
**Tsukuba-shi**
**Ibaraki 305-0035 (JP)**

(74) Representative: **Brunetti, Fabrizio et al**
**Cabinet Beau de Loménie**
**158, rue de l'Université**
**75340 Paris Cedex 07 (FR)**

(56) References cited:
**WO-A1-2007/058232    US-A1- 2005 017 244**
**US-A1- 2005 199 880**

• **KAZUO SATOH: 'Electrical and optical properties of Al-doped ZnO-Sn02 thin films deposited by RF magnetron sputtering' THIN SOLID FILMS, [Online] vol. 516, no. 17, 18 October 2007, pages 5814 - 5817 Retrieved from the Internet: <URL: http: //www.sciencedirect.com> [retrieved on 2008-12-05]**

## Description

## Technical Field

The present invention relates to an oxide semiconductor material that functions as a semiconductor active layer, a method for manufacturing the oxide semiconductor material, and an electronic device such as a field effect transistor using thereof.

## Background Art

Oxide semiconductor materials have been used as materials for electronic devices such as field effect transistors. A thin-film transistor (TFT) is an example of a field effect transistor. Such electronic devices have been used as drive elements of liquid crystal displays or EL. In a conventional TFT, an amorphous or a polycrystalline Si layer is formed on a glass substrate, a source electrode and a drain electrode are provided on both ends of the Si layer, and a gate electrode is provided in the center or at the rear surface side of the Si layer. Several materials have been tested for applications to such electronic devices.

Japanese Patent Application Laid-open No. 2003-298062 discloses a TFT in which a base film, an oxide semiconductor film composed of ZnO, a gate insulating film, and a gate electrode are successively formed on a substrate. The oxide semiconductor film using ZnO as the constituent material can lower a crystal formation temperature. In the case of the ZnO, oxygen defects are easily formed and a number of carrier electrons are generated.

Japanese Patent Application Laid-open No. 2000-044236 discloses an electrode material in the form of an amorphous oxide film composed of $Zn_xM_yIn_zO_{(x+3y/2+3z/2)}$ (M is Al or Ga: x, y, z are appropriate coefficients), an electron carrier concentration of the amorphous oxide film is at least 1 $\times$ $10^{18}$/cm$^3$ and such a film is advantageous as a transparent electrode. Thus, it is known that a film with a high electric conductivity can be formed based on the fact that a large number of carrier electrons are easily generated in the case of such an oxide containing In.

Japanese Patent Application Laid-open No. 2006-165532 discloses a TFT using an amorphous oxide film with an electron carrier concentration of less than 1 $\times$ $10^{18}$/cm$^3$ in a channel (semiconductor active layer). More specifically, $InGaO_3(ZnO)_m$ (m is an appropriate coefficient) is used as the amorphous oxide film. Thus, it is described that in the case of $InGaO_3(ZnO)_m$, an electron carrier concentration of less than $1 \times 10^{18}$/cm$^3$ can be obtained by controlling the conditions of oxygen atmosphere during film formation. Further, it is disclosed that the film is preferably formed in atmosphere containing oxygen gas, without intentional addition of dopant ions. More specifically, it is disclosed that a normally-off transistor can be configured by producing a thin transparent amorphous oxide film in an atmosphere with an oxygen partial pressure of less than 6.5 Pa.

Japanese Translation of PCT Application No. 2006-528843 discloses a semiconductor device having a channel layer composed of a ternary compound containing zinc, tin, and oxygen.

Thus, in the conventional electronic devices, ZnO (Japanese Patent Application Laid-Open No. 2003-298062), $InGaO_3(ZnO)_m$ (Japanese Patent Application Laid-Open No. 2006-165532), $Zn_xSn_yO_z$ (Japanese Translation of PCT Application No. 2006-528843) are known, for example, as oxide semiconductor materials for a TFT channel. Further, for example, ITO (Indium Tin Oxide) is a typical oxide semiconductor material as a transparent electrode material or the like, and oxide semiconductor materials containing In, such as $Zn_xM_y$-$In_zO_{(x+3y/2+3z/2)}$ (Japanese Patent Application Laid-Open No. 2000-044236) and $InGaO_3(ZnO)_m$ (Japanese Patent Application Laid-Open No. 2006-165532) are also known.

## Disclosure of the Invention

However, a low electron carrier concentration is difficult to obtain in these suggested oxide semiconductor materials and they demonstrate properties of a conductor rather than a semiconductor. In other words, since a low electric conductivity is difficult to obtain in the above-described conventional oxide semiconductor materials, bias conditions make it difficult for them to function as a semiconductor having functions of both a conductor and an insulator. Accordingly, these materials cannot be said to be sufficient in the above-described point and when such oxide semiconductor materials are used, for example, for a channel (semiconductor active layer) in a field effect transistor, a normally-off field effect transistor in which the material sufficiently functions as a channel is difficult to obtain. Further, since In, which has been contained in oxide semiconductor materials and used thereof, is a scarce metal resource, there is a demand for oxide semiconductor materials containing no In.

WO 2007/058232 discloses a ZnSnO semiconductor according to the preamble of claim 1.

With the foregoing in view, it is an object of the present invention to provide an oxide semiconductor material that can stand its practical use, an electronic device such as a field effect transistor using the oxide semiconductor material, and a method for manufacturing the oxide semiconductor material.

The inventors have conducted a study of oxide semiconductor materials aimed at the resolution of the above-described problems and finally completed the present invention.

The present invention according to the claims provides (1) to (7).

(1) An oxide semiconductor material comprising Zn, Sn, and O, containing no In, and having an electron carrier concentration higher than $1 \times 10^{15}/cm^3$ and less than $1 \times 10^{18}/cm^3$.

(2) The oxide semiconductor material according to (1), further comprising a dopant.

(3) The oxide semiconductor material according to (1) or (2), wherein the dopant is at least one member selected from the group consisting of Al, Zr, Mo, Cr, W, Nb, Ti, Ga, Hf, Ni, Ag, V, Ta, Fe, Cu, Pt, Si, and F.

(4) The oxide semiconductor material according to any one of (1) to (3), wherein the oxide semiconductor material is amorphous.

(5) An oxide semiconductor material comprising a semiconductor layer formed of the oxide semiconductor material according to any one of (1) to (4) and an electrode provided on the semiconductor layer.

(6) A field effect transistor comprising: a semiconductor layer formed of the oxide semiconductor material according to any one of (1) to (4), a source electrode and a drain electrode which are arranged in separation from each other on the semiconductor layer; and a gate electrode placed at a position where the gate electrode can apply a bias potential to a region of the semiconductor layer positioned between the source electrode and the drain electrode.

(7) A method of manufacturing an oxide semiconductor material, comprising steps (i) to (iv):

(i) a step of preparing an oxide target containing Zn, Sn, and O;
(ii) a step of placing a substrate in a chamber;
(iii) a step of placing the oxide target in the chamber, and
(iv) a step of depositing a target material on the substrate by sputtering with rare gas the oxide target placed in the chamber, wherein a dopant material is further placed in a position where it is sputtered simultaneously with the oxide target during the sputtering.

**Brief Description of the Drawings**

FIG. 1 is a plan view of a thin-film transistor 10.

FIG. 2 is a cross-sectional view taken along the II-II arrow of the thin film 10 shown in FIG. 1.

FIG. 3 shows an IV characteristic of the TFT of Embodiment 1.

FIG. 4 shows an IV characteristic of the TFT of Embodiment 2.

FIG. 5 shows an IV characteristic of the TFT of Embodiment 3.

FIG. 6 shows the relationship between the oxygen concentration and the electron carrier concentration.

FIG. 7 shows the relationship between the oxygen concentration and the electron carrier concentration.

**Explanation of Reference Numerals**

1 G    gate electrode,
1C    gate insulating film,
1S    source electrode,
1D    drain electrode,
2    semiconductor layer.

**Best Mode for Currying Out the Invention**

An oxide semiconductor material in accordance with the present invention contains zinc (Zn), tin (Sn), and oxygen (O), contains no In, and has an electron carrier concentration of higher than $1 \times 10^{15}/cm^3$ and less than $1 \times 10^{18}/cm^3$.

The inventors of the present application have provided an oxide semiconductor material of a Zn-Sn-O system, the material having an electron carrier concentration of higher than $1 \times 10^{15}/cm^3$ and less than $1 \times 10^{18}/cm^3$ despite the absence of In. In accordance with such an oxide semiconductor material, the electron carrier concentration is within an adequate range, and when such an oxide semiconductor material is used, it can sufficiently function as a semiconductor active layer. Therefore, such an oxide semiconductor material can be advantageously used for an electronic device such as a normally-off field effect transistor.

The oxide semiconductor material further contains a dopant.

The oxide semiconductor material already contains oxygen, but by further containing a dopant that is an element other than oxygen, it is possible to obtain an oxide semiconductor material that has a low electron carrier concentration, that is, a sufficiently high sheet resistance and better utility.

The oxide semiconductor material contains at least one member selected from the group consisting of Zr, Mo, Cr, W, Nb, Hf, Ni, Ag, V, Ta, Fe, Cu, Pt, Si, and F, as a dopant.

When any one of these elements is used as a dopant, it is possible to obtain an oxide semiconductor material that has a sufficiently high sheet resistance and better utility.

The oxide semiconductor material is preferably amorphous. When the oxide semiconductor material is amorphous it is possible to obtain an oxide semiconductor material having a high sheet resistance.

An electronic device in accordance with the present invention includes a semiconductor layer composed of the above-described oxide semiconductor material and an electrode provided on the semiconductor layer.

Since the oxide semiconductor material has the above-described sufficient characteristics, an electric current flowing in the semiconductor layer through the electrodes can be controlled by a bias potential.

A field effect transistor in accordance with the present invention includes a semiconductor layer composed of the above-described oxide semiconductor material, a source electrode and a drain electrode which are arranged by being separated from each other on the semiconductor layer, and a gate electrode placed at a position where the gate electrode can apply a bias potential to a region of the semiconductor layer positioned between the source electrode and the drain electrode.

When a predetermined bias potential is applied to a semiconductor layer arranged between the source electrode and the drain electrode in the field effect transistor, a channel is formed between the source and the drain and a current flows between the source and the drain. As described hereinabove, the resistance in this region of the semiconductor layer is high when no bias potential is applied and therefore the device can sufficiently function as a field effect transistor. Further, when the oxide semiconductor material in accordance with the present invention is used for TFT formed in pixels of a liquid crystal display or the like, the transparency of the oxide semiconductor material makes it possible to increase the essential numerical aperture of the pixels.

The oxide semiconductor material can be manufactured by a method including a step of preparing an oxide target containing Zn, Sn, and O; a step of placing a substrate in a chamber; a step of placing the oxide target in the chamber, and a step of depositing a target material on the substrate by sputtering the oxide target placed in the chamber with rare gas, and additionally including a step of introducing oxygen gas into the chamber during the sputtering, wherein a volume ratio of oxygen gas in a gas mixture of the rare gas and oxygen gas is set appropriately, for example.

When the oxide target is sputtered by rare gas, a target material is deposited on the substrate. Oxygen gas as well as rare gas may be introduced into the chamber during sputtering.

Further, the oxide semiconductor material can be manufactured by a method including a step of preparing an oxide target containing Zn, Sn, and O; a step of placing a substrate in a chamber; a step of placing the oxide target in the chamber, and a step of depositing a target material on the substrate by sputtering the oxide target placed in the chamber with rare gas, wherein a dopant material is further placed in a position where it is sputtered simultaneously with the oxide target during sputtering, for example. Examples of a dopant material include materials composed of the above-described dopant, an oxide containing the above-described dopant and fluorides containing the above-described dopant.

When the oxide target is sputtered by rare gas, a target material is deposited on the substrate. Since the dopant material is placed in the target or in the vicinity thereof, the dopant is further contained in the oxide semiconductor material manufactured by the sputtering. Therefore, the oxide semiconductor material has a sheet resistance capable of standing practical use of electronic devices. The above-listed elements can be used as the dopant elements.

The oxide semiconductor material according to the embodiments and thin-film transistors (field effect transistor: electronic device) using thereof are described below in greater detail. In the explanation below, like components are denoted using like reference symbols and redundant explanation thereof is omitted.

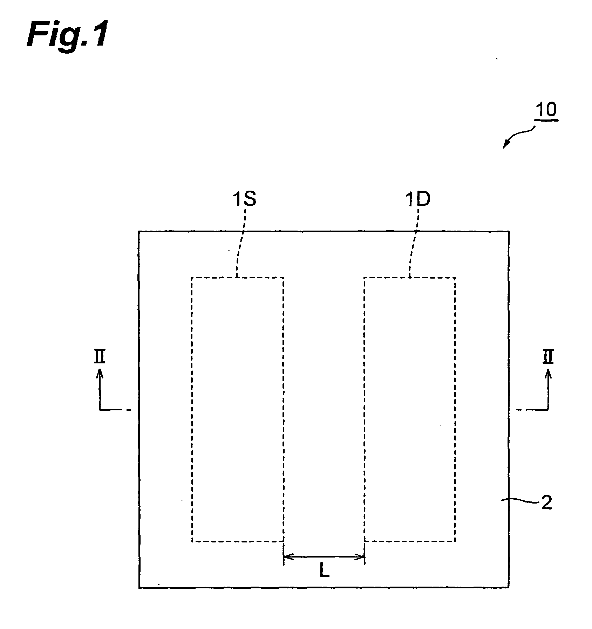

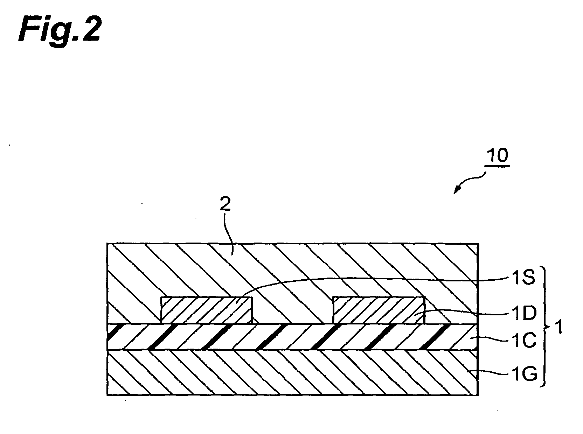

FIG. 1 is a plan view of the thin-film transistor 10. FIG. 2 is a cross sectional view taken along the II-II arrow of the thin film 10 shown in FIG. 1.

A gate insulating layer 1C and also a source electrode 1S and a drain electrode 1D which are arranged by being separated from each other are successively laminated on a gate electrode 1G, thereby configuring a substrate 1. A semiconductor layer 2 composed of an oxide semiconductor material X is deposited on the substrate 1. A region of the semiconductor layer 2 between the source electrode 1S and the drain electrode 1D functions as a channel of the thin-film transistor 10.

In the present example, a channel length L, which is a distance between the source electrode 1S and the drain electrode 1D of the thin-film transistor 10, and a channel width W, which is a width of the source electrode 1S or the drain electrode 1D, are set as follows.

- Channel length L = 20 $\mu$m
- Channel width W = 1 mm

The thin-film transistor 10 includes the semiconductor layer 2 composed of the N-type oxide semiconductor material X and the electrodes (the source electrode 1S or the drain electrode 1D) provided on the semiconductor layer 2. Since the oxide semiconductor material X in the thin-film transistor 10 has sufficient characteristics, as described hereinbelow, the thin-film transistor 10 can control an electric current flowing in the semiconductor layer 2 through the electrodes by a bias potential thereof. When the semiconductor layer 2 and one electrode are brought in Schottky contact, and the other electrode is brought in ohmic contact, a Schottky diode can be configured as an electronic device in which the electric current flowing in the oxide semiconductor material X can be controlled correspondingly to the voltage applied between the two electrodes.

In the present example, the electronic device is the thin-film transistor 10 and includes the semiconductor layer 2 composed of the oxide semiconductor material, the source electrode 1S and the drain electrode 1D arranged by being separated on the semiconductor layer 2, and a gate electrode 1G placed at a position where the gate electrode can apply a bias potential to a region of the semiconductor layer 2 positioned between the source electrode 1S and the drain electrode 1D.

When a predetermined bias potential is applied to the semiconductor layer 2 positioned between the source electrode 1S and the drain electrode 1D in the thin-film transistor 10, a channel is formed between the source and the drain, and a current flows between the source and the drain. Since the resistance in this region of the semiconductor layer 2 is high in a state in which no bias potential is applied, as described hereinabove, the device can sufficiently function as a field effect transistor.

The semiconductor region being in contact with the source electrode 1S and the drain electrode 1D is of N type. Normally, no current flows in the N-type channel due to the resistance of the semiconductor layer, and a cross-sectional area of the channel increases due to the application of a gate voltage, and the amount of current flowing in the channel increases following the increase in a gate voltage. In the present example, the resistance value of the semiconductor layer is sufficiently high and the device essentially functions as a normally-off thin-film transistor.

The source electrode 1S and the drain electrode 1D are in ohmic contact with the semiconductor layer 2, and the contact region thereof constitutes the source and the drain. Analysis conducted with an in-air photoelectronic spectrometer AC2 manufactured by Riken Keiki Co., Ltd. confirmed that a Fermi level of the semiconductor layer of the present embodiment is rather similar to that of Au and no significant problem is associated with charge injection.

Materials of the components constituting the thin-film transistor 10 are described below.

- Gate electrode 1G: Si
- Gate insulating layer 1C: $SiO_2$
- Source electrode 1S: Au/Cr
- Drain electrode 1D: Au/Cr
- Semiconductor layer 2: oxide semiconductor material X

A dopant is added at a high concentration to Si constituting the gate electrode 1G, and the gate electrode 1G has electric conductivity close to that of metals.

The oxide semiconductor material X is described below.

The oxide semiconductor material X is an amorphous compound semiconductor containing Zn, Sn, and O and is composed of a Zn-Sn-O film (a Zn : Sn : O composition ratio is 2 : 1 : 4). The oxide semiconductor material X is a compound of Zn, Sn, and O and contains no In. The electron carrier concentration $C_x$ thereof is higher than $1 \times 10^{15}/cm^3$ and less than $1 \times 10^{18}/cm^3$. The expression "contains no In" in the present description means that no step of adding In is involved in the manufacturing process and that the oxide semiconductor material contains substantially no In. The oxide semiconductor material X usually has an In content of less than 0.01 wt.%. The In content is found, for example, by emission spectral analysis.

More specifically, depending on the presence of an element D as a dopant, physical properties of the oxide semiconductor material X can be classified into the below-described Type I (contains no dopant D) and Type II (contains element D). The element D is an element other than oxygen. Zn and Sn in the semiconductor layer are the main components, and the ratio of the total weight thereof to the entire weight in Type I (contains no dopant D) is equal to or greater than 78 wt.%.

Type I

Data presented below relate to the case in which no element D is contained as a dopant. Vs is a unit indicating volt-sec.

- Constituent elements: Zn, Sn, O
- Electron carrier concentration $C_X$: $1 \times 10^{15}/cm^3 < C_X < 1 \times 10^{18}/cm^3$
- Film thickness $t_X$: 10 nm $\leq t_X \leq$ 1000 nm
- Crystallinity: amorphous
- Sheet resistance $R_X$: $10^4$ Ω/sq. $\leq R_X \leq 10^9$ Ω/sq.
- Mobility $\mu_X$: 1 $cm^2$/Vs $\leq \mu_X$
- In content $W_{In}$: $W_{In} \approx 0$ (wt.%)

Type II

In the case in which an element D is contained as a dopant, the oxide semiconductor material X has the following physical properties.

- Constituent elements: Zn, Sn, O
- Electron carrier concentration $C_X$: $1 \times 10^{15}/cm^3 < C_X < 1 \times 10^{18}/cm^3$
- Film thickness $t_X$: 10 nm $\leq t_X \leq$ 1000 nm
- Crystallinity: amorphous
- Sheet resistance $R_X$: $10^4$ Ω/sq. $\leq R_X \leq 10^9$ Ω/sq.
- Mobility $\mu_X$: 1 $cm^2$/Vs $\leq \mu_X$
- In content $W_{In}$: $W_{In} \approx 0$ (wt.%)
- Dopant: element D
- Concentration $C_D$ of element D: 0 mol% $< C_D \leq$ 10 mol%

Here, $C_D$ = ((Number of moles of D)/(Number of moles of D + Number of moles of Zn + Number of moles of Sn)) $\times$ 100%.

The inventors of the present application are the first to provide the oxide semiconductor materials X of Type I and Type II of a Zn-Sn-O system, the materials having an electron carrier concentration $C_X$ of higher than $1 \times 10^{15}/cm^3$ and less than $1 \times 10^{18}/cm^3$, despite no In is contained. Since the electron carrier concentration $C_X$ of these oxide semiconductor material X is decreased, the carrier mobility $\mu_X$ can be increased to a level suitable for practical use.

Thus, when the electron carrier concentration

$C_X$ is higher than $1 \times 10^{15}/cm^3$ and less than $1 \times 10^{18}/cm^3$, the electric conductivity of the oxide semiconductor material X is within an adequate range and the oxide semiconductor material can function as a semiconductor active layer that can be made conducting or insulating, depending on the bias.

A more preferred range for the electron carrier concentration $C_X$ is from $10^{16}/cm^3$ to $10^{17}/cm^3$. When $C_X$ is equal to or higher than the lower limit value, the effect is that the ON current increases, and when $C_X$ is equal to or less than the upper limit value, the effect is that the OFF current decreases, and the ratio of the ON current and OFF current can be increased.

The oxide semiconductor material X of Type II further contains the element D as a dopant composed of an element other than oxygen. Oxygen is already contained in the oxide semiconductor material X and an oxide semiconductor material having a suitably low electron carrier concentration $C_X$ in practical use, that is, a sufficiently high sheet resistance $R_X$, can be obtained even when the element D, which is an element other than oxygen, is added to the oxide semiconductor material X. From the standpoint of improving stability of the semiconductor layer in time and facilitating the manufacture of TFT, it is preferred that the oxide semiconductor material X be an oxide containing the doping element D.

At least one element selected from the element group consisting of the below-described metal elements D1, semi-metal elements D2, and non-metal elements D3 can be used as the element D.

Element D

- Metal element D1: at least one member selected from the group consisting of Al, Zr, Mo, Cr, W, Nb, Ti, Ga, Hf, Ni, Ag, V, Ta, Fe, Cu, and Pt
- Semiconductor element D2: Si
- Non-metal element D3: F

When the above-described element D is used as a dopant, it is possible to obtain an oxide semiconductor material having a sufficiently high sheet resistance.

A crystallinity of the oxide semiconductor material X of the present embodiment is amorphous. The inventors of the present application have confirmed that an oxide semiconductor material suitable for practical use can be obtained when the oxide semiconductor material X is at least amorphous. However, since the mobility generally tends to increase with the increase in crystallinity, the oxide semiconductor material X will apparently have sufficient mobility even in a polycrystalline or single crystal state.

The above-described oxide semiconductor material is manufactured by successively executing the following steps (i) to (iv). The order of steps (ii) and (iii) can be reversed.

(i) a step of preparing an oxide target containing Zn, Sn, and O;
(ii) a step of placing a substrate in a chamber;
(iii) a step of placing the oxide target in the chamber, and
(iv) a step of depositing a sputtered target material on the substrate by sputtering the oxide target placed in the chamber with rare gas.

Type I

In the case of Type I, oxygen gas is introduced into the chamber during sputtering in step (iv). The volume ratio $C_{GAS}$ (vol.%) of oxygen gas contained in a gas mixture of rare gas and oxygen gas may be higher than 0% and equal to or less than 20%. In the case of Type II, $C_{GAS}$ (vol.%) may be equal to or higher than 0% and equal to or less than 20%.

When the oxide target is sputtered by the rare gas, the target material is deposited on the substrate. The oxygen gas as well as the rare gas is introduced into the chamber during sputtering.

When oxygen vacancies appear in the film constituted by the oxide semiconductor material of a Zn-Sn-O system, these oxygen vacancies generate electron carriers. But because the oxygen gas is introduced in a predetermined amount during sputtering, when the film is formed, the amount of oxygen vacancies is reduced and therefore, the electron carrier concentration is decreased to a level suitable for practical use.

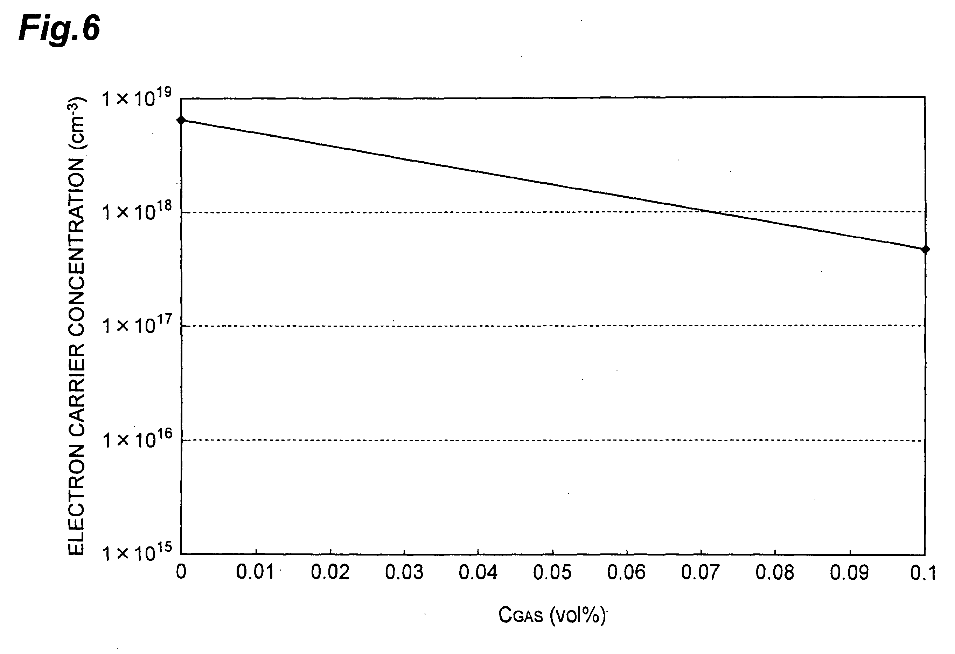

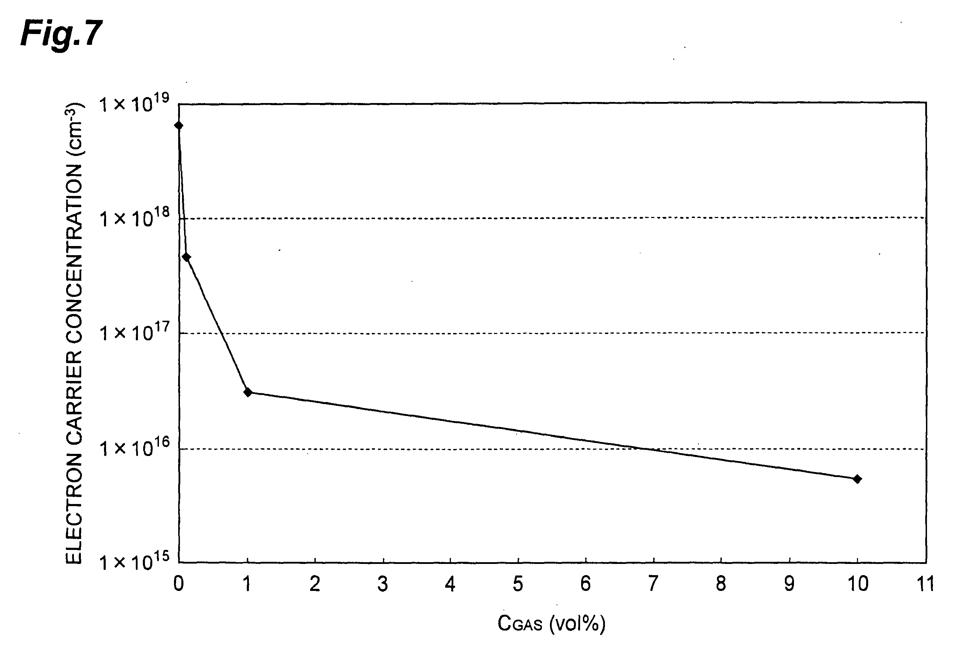

FIG. 6 is a graph showing the relationship between the oxygen concentration $C_{GAS}$ (vol.%) and the electron carrier concentration $(cm^{-3})$ in the case in which $C_{GAS}$ is 0 vol.% to 0.1 vol.%. FIG. 7 is a graph showing the relationship between the oxygen concentration $C_{GAS}$ (vol.%) and the electron carrier concentration $(cm^{-3})$ in the case in which $C_{GAS}$ is 0 vol.% to 10 vol.%.

When $C_{GAS}$ (vol.%) is equal to 0.1 vol.% or higher and equal to 10 vol.% or less, the semiconductor layer 2 is confirmed to have sufficient insulating ability when no bias is applied. When the electron carrier concentration is predicted by representing graphically the relationship with the electron carrier concentration in the case of 0 vol.%, 0.1 vol.%, 1 vol.%, and 10 vol.%, as described hereinabove, the electron carrier concentration can be predicted to be made equal to or less than the electron carrier concentration $(=1 \times 10^{18} cm^{-3})$, such at which no leak occurs, when the oxygen concentration $C_{GAS}$ is equal to or higher than 0.07 vol.%, and the effect is that the ON current can be increased when the oxygen concentration $C_{GAS}$ is equal to or less than 20 vol.%.

It is more preferred that $C_{GAS}$ (vol.%) be equal to or higher than 0.5 vol.% and equal to or less than 5 vol.%. In this case, when the $C_{GAS}$ (vol.%) is equal to or higher than the lower limit value, the effect is that the OFF current can be further reduced, and when the $C_{GAS}$

(vol.%) is equal to or less than the upper limit value, the effect is that the ON current can be further increased. In particular, when C$_{GAS}$ (vol.%) is equal to or higher than 1 vol.%, the degree of variation of the electron carrier concentration to the concentration abruptly decreases and the electron carrier concentration can be controlled with high accuracy.

Type II

In the case of Type II, a dopant other than oxygen is placed in the target or in the vicinity thereof, and this dopant is introduced in a sputtered target material. When the oxide target is sputtered by rare gas, a target material is deposited on the substrate. Since the dopant has been further introduced into the target material, the deposited target material has a sheet resistance sufficient for practical use in an electronic device. The above-described member can be used as the dopant element.

In the case of Type II, the dopant may be introduced into the oxide semiconductor material so that the electron carrier concentration in the oxide semiconductor material becomes optimum when the material is sputtered with the rare gas containing no oxygen. When the amount of dopant in the oxide semiconductor material is decreased and sputtering is conducted with the rare gas containing no oxygen, the electron carrier concentration increases, but the electron carrier concentration may be reduced and the electron carrier concentration in the oxide semiconductor material may be set to an optimum value by conducting sputtering with rare gas having oxygen added thereto.

Each step is described below in detail.

Step (i): step of manufacturing an oxide target

A zinc oxide (ZnO) powder and a tin oxide (SnO$_2$) powder are weighed to obtain a Zn: Sn molar ratio of M1: M2 and mixed in a dry ball mill. The obtained mixed powder is put into an alumina crucible, calcined by holding for H1 (hour) at T1 (°C) in oxygen atmosphere, and pulverized in a dry ball mill. The obtained calcined powder is molded into a disk under a pressure of G1 (kg/cm$^2$) by uniaxial pressing in a die and then pressurized under G2 (kg/cm$^2$) by cold isostatic pressing (CIP). The obtained molded body is sintered by holding for H2 (hour) at T2 (°C) under a pressure of P1 (hPa) in oxygen atmosphere, and a sintered body is obtained. Both surfaces of the obtained sintered body are polished with a flat-surface grinding machine and an oxide target is fabricated.

In the case of manufacturing the oxide semiconductor material of Type II, the element D (or an oxide thereof) powder is mixed in addition to the zinc oxide powder and the tin oxide powder when initially mixed, or a chip containing the element D is placed in the vicinity of the target when sputtered.

Step (ii): step of preparing a substrate

The chamber is a chamber of a sputtering equipment. A fixing member for a target and a fixing member for the substrate 1 are placed in the chamber and these fixing members are disposed facing each other. The substrate 1 is fixed to the fixing member for the substrate 1. The fixing member for the substrate 1 is provided with a heater, and the substrate temperature during deposition can be adjusted.

The gate insulating layer 1C and the electrode layer are successively deposited on the gate electrode 1G and the very last electrode layer is patterned by photolithography, thereby forming the source electrode 1S and the drain electrode 1D and producing the substrate 1.

Step (iii): step of placing the oxide target

The oxide target is fixed to the fixing member for the target inside the chamber. After the oxide target and the substrate 1 have been fixed, the chamber is sealed, the gas located inside the chamber is pumped out with a vacuum pump, and the inside of the chamber is evacuated.

Step (iv): film formation step

After the inside of the chamber has been evacuated, gas species 1 (Type I) or gas species 2 (Type II) is introduced into the chamber, a high-frequency (RF) plasma is generated, sputtering of the oxide target is conducted, and the target material is deposited on the substrate. The rare gas of the present example is Ar, but rare gases of other kinds can be also used. Conditions when the film is formed are presented below.

Type I

- Manufacturing method: RF sputtering method
- Target: Zn-Sn-O sintered body
- Gas species R1: Ar-O$_2$ mixed gas
- Volume concentration of O$_2$ in gas species R1: C$_{GAS}$ (vol.%)
- Pressure inside the chamber: P2 (Pa)
- Substrate temperature: T3 (°C)
- Sputtering power: W$_P$ (W)
- Deposition time: H3 (hour)

Type II

- Manufacturing method: RF sputtering method
- Target: Zn-Sn-O sintered body + chip containing element D
- Gas species R2: Ar gas

- Pressure inside the chamber: P2 (Pa)
- Substrate temperature: T3 (°C)
- Sputtering power: $W_P$ (W)
- Deposition time: H3 (hour)

The preferred range for each parameter is presented below.

(a) $0.5 \leq M1/M2 \leq 3$
(b) $500 \leq T1 \leq 1200$
(c) $1 \leq H1 \leq 240$
(d) $100 \leq G1 \leq 1000$
(e) $500 \leq G2 \leq 10000$
(f) $101.325 \leq P1 \leq 10132.5$
(g) $1000 \leq T2 \leq 1600$
(h) $1 \leq H2 \leq 240$
(i) $0.1 \leq P2 \leq 10$
(j) RT (room temperature = 26) $\leq T3 \leq 1200$
(k) $1/60 \leq H3 \leq 10$
(l) $10 \leq W_p \leq 1000$
(m) $0 \leq C_{GAS} \leq 20$

The above-mentioned parameters satisfy the following relationships.

(o) $G1 \leq G2$
(p) $T1 \leq T2$

When the parameters satisfy at least the above-mentioned ranges, it is apparently possible to manufacture an oxide semiconductor material that makes it possible to manufacture a transistor that works practically.

EXAMPLES

Common Conditions

The above-described oxide semiconductor material X was deposited on the substrate 1 by the above-described manufacturing method and the thin-film transistor 10 was manufactured. A powder manufactured by Kojundo Chemical Laboratory Co., Ltd and having a purity of 99.99% was used as the zinc oxide powder (ZnO), and a powder manufactured by Kojundo Chemical Laboratory Co., Ltd and having a purity of 99.99% was used as the tin oxide powder ($SnO_2$). Zirconia balls with a diameter of 5 mm were used for the dry ball mill.
A glass substrate (Coming 1737) was prepared for monitoring the film thickness and film properties and placed in the sputtering equipment. Ultrasonic degreasing and cleaning of this substrate were conducted as pretreatment for film formation.

Conditions of Example 1

(1-1) Manufacture of oxide target:

- M1/M2 = 2
- T1 = 900 (°C)
- H1 = 5 (hour)
- G1 = 500 (kg/cm$^2$)
- G2 = 1600 (kg/cm$^2$)
- P1=1013(hPa)
- T2 = 1200 (°C)
- H2 = 5 (hour)

The density of the manufactured oxide target (Zn-Sn-O sintered body) was 5.43 g/cm$^3$. Both surfaces of the sintered body thus obtained were polished with a flat-surface grinding machine, and the sintered body was machined to a diameter of 76.2 mm and a thickness of 6 mm and bonded to a backing plate to produce an oxide target.

(1-2) Manufacture of substrate:

- Gate electrode material: Si
- Gate insulating film material: $SiO_2$
- Source and drain electrode material: Au/Cr
- Channel length L = 20 $\mu$m
- Channel width W = 1 mm

(1-3) Film formation:

- Manufacturing method: RF sputtering method
- Target: Zn-Sn-O sintered body
- Gas species R1: Ar-$O_2$ mixed gas
- Oxygen concentration $C_{GAS}$: 1 vol.%
- Pressure inside the chamber P2: 0.5 Pa
- Substrate temperature T3: 200°C
- Sputtering power Wp: 50 W
- Deposition time H3: 1 hour

Evaluation Method and Evaluation Results:

X-ray diffraction was performed on the obtained thin film. No clear diffraction peaks were detected and the crystallinity of the produced Zn-Sn-O film (semiconductor layer 2) was amorphous. The thickness of the semiconductor layer 2 was 103.7 nm. The thin film formed on the glass substrate was visually transparent. The transmissivity at a wavelength of 550 nm (including the glass substrate) was 87.8%, and the average transmissivity from a wavelength of 380 nm to a wavelength of 780 nm was 85.2%. Specific resistance and mobility of the obtained thin film were found by Hall measurements. The electron carrier concentration of the obtained Zn-Sn-O amorphous oxide film was $3.08 \times 10^{16}$/cm$^3$ and the electron mobility was 5.36 cm$^2$/Vs.

Film Properties:

The semiconductor layer formed in Example 1 in the above-described manner had the following properties.

- Semiconductor layer material: Zn-Sn-O (compound)
- Crystallinity: amorphous
- Film thickness: 103.7 nm
- Electron carrier concentration $C_X$: $3.08 \times 10^{16}$/cm$^3$
- Electron mobility $\mu_X$: 5.36 cm$^2$/Vs
- Specific resistance $\rho_X$: 3.67 $\Omega$cm
- Sheet resistance $R_X$: $3.54 \times 10^5$ $\Omega$/sq.

IV Characteristic of TFT

A probe was set from the surface of the semiconductor layer on the source electrode and drain electrode positioned inside the formed semiconductor layer, the probe tips were brought into contact with the electrodes, and an IV characteristic ofTFT was measured.

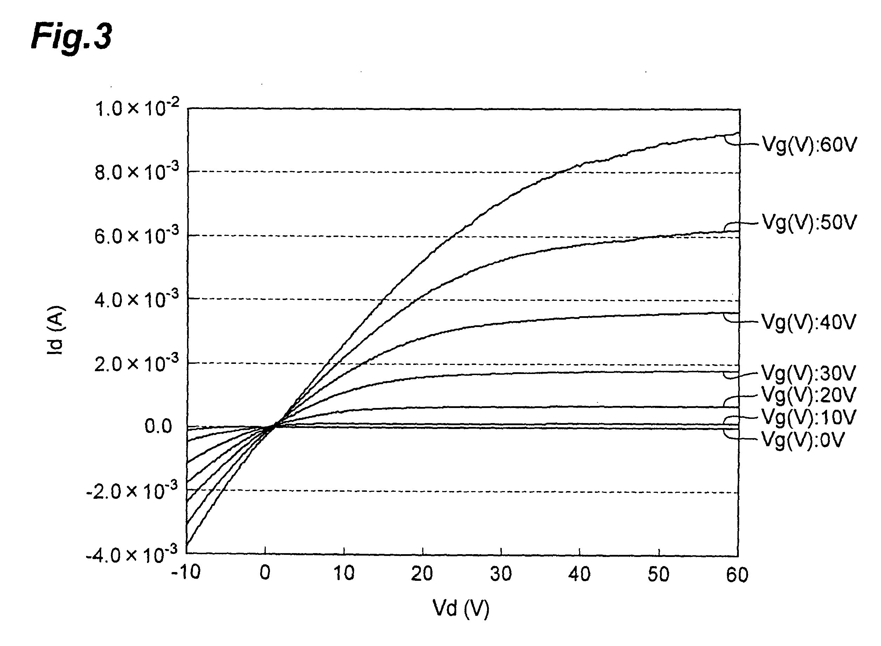

FIG. 3 shows a current - voltage characteristic of a TFT device measured at room temperature. Since the drain current Id increased with the increase in drain voltage Vd, it was clear that the channel has n-type conductivity. This result does not contradict the fact that the amorphous Zn-Sn-O oxide film is an N-type conductor. The drain current Id demonstrated the behavior of a typical semiconductor transistor with saturation (pinch-off) at a drain voltage Vd of about 30 V.

At a gate voltage Vg of 60 V, the drain current Id was $9 \times 10^{-3}$ A. This result corresponded to the fact that carriers could be induced in the semiconductor layer by a gate bias potential.

The maximum current Imax was 10 mA, the reverse leak current was equal to or less than 0.01 $\mu$A and good transistor characteristic was demonstrated. The drain current ratio during transistor ON/OFF was equal to or greater than $1 \times 10^6$. The mobility calculated from a saturation region of a transfer characteristic of the transistor that represents the relationship between a gate voltage and a drain current was about 10 cm$^2$/Vs.

Conditions of Example 2

A TFT was fabricated under the same conditions as in Example 1, except that the oxygen concentration $C_{GAS}$ during sputtering was 0.1 vol.%.

Evaluation Method and Evaluation Results:

X-ray diffraction was performed on the obtained thin film. No clear diffraction peaks were detected and the crystallinity of the produced Zn-Sn-O film (semiconductor layer 2) was amorphous. The film thickness was 105.5 nm. The film formed on the glass substrate (1737, manufactured by Corning Incorporated) was visually transparent. Specific resistance and mobility of the transparent conductive thin film obtained by sputtering were found by Hall measurements. The electron carrier concentration of the obtained semiconductor layer was $4.64 \times 10^{17}$/cm$^3$ and the electron mobility was 10.8 cm$^2$/Vs.

Film Properties:

The semiconductor layer formed in Example 2 had the following properties.

- Semiconductor layer material: Zn-Sn-O (compound)
- Crystallinity: amorphous
- Film thickness: 105.5 nm
- Electron carrier concentration $C_X$: $4.64 \times 10^{17}$/cm$^3$
- Electron mobility $\mu_X$: 10.8 cm$^2$/Vs
- Specific resistance $\rho_X$: 1.25 $\Omega$cm
- Sheet resistance $R_X$: $1.18 \times 10^5$ $\Omega$/sq.

IV Characteristic of TFT

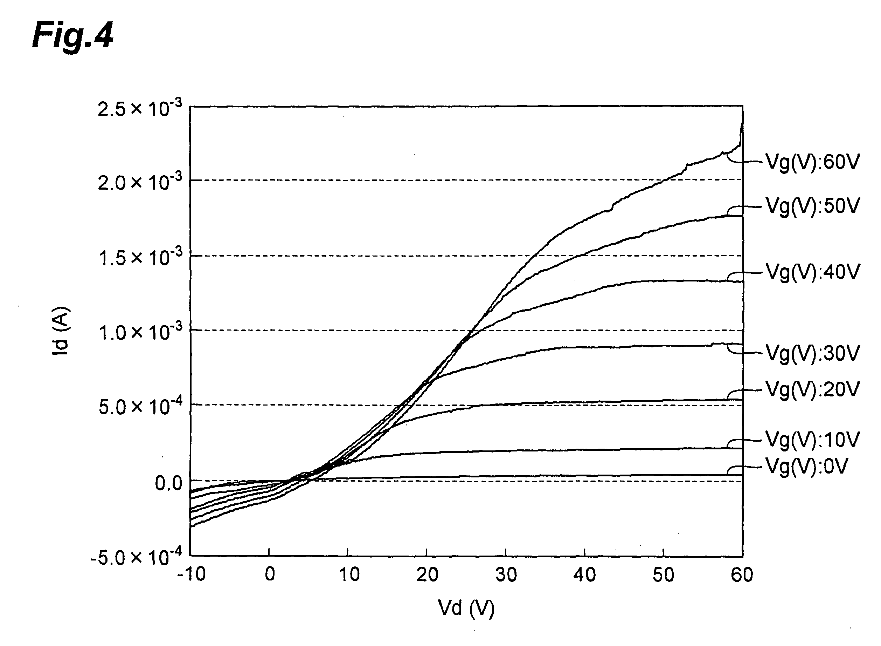

FIG. 4 shows a current - voltage characteristic of a TFT device measured at room temperature. The measurement method was identical to that of Example 1. In Example 2, a TFT device could be produced that had good transistor characteristic, although not as good as in Example 1, even at an oxygen concentration of 0.1 vol.%.

Conditions of Example 3

A TFT was fabricated under the same conditions as in Example 1, except that the oxygen concentration $C_{GAS}$ during sputtering was 10 vol.%.

Evaluation Method and Evaluation Results:

X-ray diffraction was performed on the obtained thin film. No clear diffraction peaks were detected and the crystallinity of the produced Zn-Sn-O film (semiconductor layer 2) was amorphous. The thickness of the semiconductor layer 2 was 89 nm. The film formed on the glass substrate (1737, manufactured by Coming Incorporated) was visually transparent. Specific resistance and mobility of the transparent conductive thin film obtained by sputtering were found by Hall measurements. The electron carrier concentration of the obtained semiconductor layer was $5.45 \times 10^{15}$/cm$^3$ and the electron mobility was 5.02 cm$^2$/Vs.

Film Properties:

The semiconductor layer formed in Example 3 had the following properties.

- Semiconductor layer material: Zn-Sn-O (compound)
- Crystallinity: amorphous
- Film thickness: 89 nm
- Electron carrier concentration $C_X$: $5.45 \times 10^{15}$/cm$^3$

- Electron mobility $\mu_X$: 5.02 cm$^2$/Vs
- Specific resistance $\rho_X$: 2.28 × 10$^2$ Ωcm
- Sheet resistance $R_X$: 2.56 × 10$^7$ Ω/sq.

## IV Characteristic of TFT

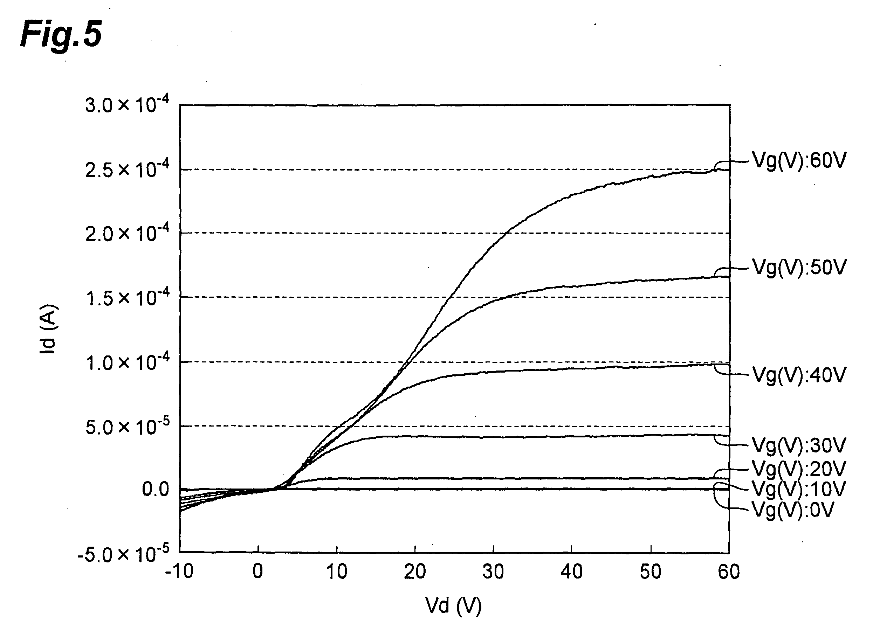

FIG. 5 shows a current - voltage characteristic of a TFT device measured at room temperature. The measurement method was identical to that of Example 1. In Example 3, a TFT device could be produced that had good transistor characteristic, although not as good as in Example 1, even at an oxygen concentration $C_{GAS}$ of 10 vol.%.

## Conditions of Comparative Example 1

A TFT was fabricated under the same conditions as in Example 1, except that the oxygen concentration $C_{GAS}$ during sputtering was 0 vol.%.

Evaluation Method and Evaluation Results:

X-ray diffraction was performed on the obtained thin film. No clear diffraction peaks were detected and the crystallinity of the produced Zn-Sn-O film (semiconductor layer 2) was amorphous. The film thickness of the semiconductor layer 2 was 111.7 nm. The film formed on the glass substrate (1737, manufactured by Coming Incorporated) was visually transparent. Specific resistance and mobility of the transparent conductive thin film obtained by sputtering were found by Hall measurements. The electron carrier concentration of the obtained semiconductor layer was 6.51 × 10$^{18}$/cm$^3$ and the electron mobility was 14.9 cm$^2$/Vs.

Film Properties:

The semiconductor layer formed in Comparative Example 1 had the following properties.

- Semiconductor layer material: Zn-Sn-O (compound)
- Crystallinity: amorphous
- Film thickness: 111.7 nm
- Electron carrier concentration $C_X$: 6.51 × 10$^{18}$/cm$^3$
- Electron mobility $\mu_X$: 14.9 cm$^2$/Vs
- Specific resistance $\rho_X$: 6.40 × 10$^{-2}$ Ωcm
- Sheet resistance $R_X$: 5.73 × 10$^3$ Ω/sq.

## IV Characteristic of TFT

The obtained TFT did not demonstrate a transistor characteristic. This was apparently because the carrier concentration inside the semiconductor layer was too high and the current leaked between the source and the drain.

## Conditions of Example 4

A thin film was formed under the same conditions as in Example 1, except that the oxide target obtained in Example 1 was placed in a chamber of a sputtering equipment, a total of eight vanadium (V) chips (manufactured by Kojundo Chemical Laboratory Co., Ltd, purity 99.9%, 5 × 5 × t1 mm) were fixedly disposed with a uniform spacing along the circumference of erosion portion of the oxide target, and Ar gas was introduced into the sputtering device. Thus, the oxygen concentration $C_{GAS}$ during sputtering was 0 vol.%.

The film formation conditions of Example 4 are presented below:

- Manufacturing method: RF sputtering method
- Target: Zn-Sn-O sintered body + V tip(s)
- Gas species R2: Ar gas
- Oxygen concentration $C_{GAS}$: 0 vol.%
- Pressure inside the chamber P2: 0.5 Pa
- Substrate temperature T3: 200°C
- Sputtering power $W_P$: 50 W
- Deposition time H3: 1 hour

Evaluation Method and Evaluation Results:

The obtained film was dissolved in an acid and metal elements were quantitatively determined by ICP-AES (inductively coupled plasma emission spectroscopy). V was contained at 0.54 wt.% and 0.93 mol% based on the metal elements (Sn, Zn, V) in the oxide film. Thus, the molar ratio $C_{DOPANT}$ of the dopant to all the constituent elements, except oxygen, in the semiconductor layer ($C_{DOPANT}$ = ((Number of moles of V)/(Number of moles of V + Number of moles of Zn + Number of moles of Sn)) × 100%) was 0.93 mol%. X-ray diffraction was performed on the obtained thin film. No clear diffraction peaks were detected and the crystallinity of the produced vanadium-doped Zn-Sn-O film (semiconductor layer) was amorphous. The film thickness of the semiconductor layer was 115.8 nm. The film formed on the glass substrate (1737, manufactured by Coming Incorporated) was visually transparent. The transmissivity at a wavelength of 550 nm (including the glass substrate) was 89.3%, and the average transmissivity from a wavelength of 380 nm to a wavelength of 780 nm was 85.1%.

Specific resistance and mobility of the transparent conductive thin film obtained by sputtering were found by Hall measurements. The specific resistance of the obtained vanadium-doped Zn-Sn-O film was 1.06 Ωcm, the electron carrier concentration was 3.45 × 10$^{17}$/cm$^3$, and the electron mobility was 17.1 cm$^2$/Vs.

Film Properties:

The semiconductor layer formed in Example 4 had the following properties.

- Semiconductor layer material: Zn-Sn-O (compound)
- Crystallinity: amorphous
- Film thickness: 115.8 nm
- Electron carrier concentration $C_X$: $3.45 \times 10^{17}$/cm$^3$
- Electron mobility $\mu_X$: 17.1 cm$^2$/Vs
- Sheet resistance $R_X$: $9.14 \times 10^4$ Ω/sq.
- Dopant content ratio $C_{DOPANT}$: 0.93 mol%

Because of the effect of vanadium, the carrier concentration could be reduced to a value equal to or less than $10^{18}$/cm$^3$ at which good transistor characteristic could be obtained, without greatly decreasing the mobility. Further, it was found that the electron carrier concentration tended to decrease with the increase in doping concentration of the doping element, thereby making it possible to control the electron carrier concentration. The preferred range of dopant content ratio $C_{DOPANT}$ is presented below.

$$0 \text{ mol\%} < C_{DOPANT} \leq 10 \text{ mol\%}$$

When $C_{DOPANT}$ is equal to or higher than the lower limit value, the carrier concentration is reduced to a suitable value, and when the dopant content ratio is equal to or less than the upper limit value, the carrier concentration does not decrease excessively, solid solution is effectively formed by doping, no precipitated phase or segregated phase occurs, and no unevenness occurs in the dopant concentration distribution.

Further, the table below shows the results obtained by measuring a sheet resistance of thin films formed in the same manner as in Example 1, except that one metal (semiconductor) chip ( length and width are 5 mm × 5 mm, thickness = 1 mm) (Ga and F are exceptions) was fixedly disposed in the erosion portion of the oxide target and Ar gas was introduced into the sputtering equipment.

When gallium and fluorine were the doping elements, a sheet resistance was measured on thin films formed in the same manner as in Example 1, except that in the case of Ga, one sintered pellet (diameter 10 mmφ, thickness = 3 mm) of gallium oxide ($Ga_2O_3$), and in the case of F, one sintered pellet (diameter 10 mm, thickness = 3 mm) of $Zn_2SnO_4$ doped with zinc fluoride ($ZnF_2$) and tin fluoride ($SnF_4$) was fixedly disposed in the erosion portion of the oxide target and Ar gas was introduced into the sputtering device.

As shown in Table 1 below, the effect similar to the above-described effect obtained with V can be obtained when doping elements (Al, Zr, Mo, Cr, W, Nb, Ti, Ga, Hf, Ni, Si, Ag, Ta, Fe, F, Cu, and Pt) are used.

Table 1. Effect of doping element on sheet resistance

| Doping element | Sheet resistance |
| --- | --- |
| | Ω/sq. |
| None | 3.05E + 03 |
| Al | 9.18E + 03 |
| Zr | 1.06E + 04 |
| Mo | 1.13E + 04 |
| Cr | 1.25E + 04 |
| W | 1.50E + 04 |
| Nb | 1.54E + 04 |
| Ti | 1.69E + 04 |
| Ga | 1.90E + 04 |
| Hf | 2.34E + 04 |
| Ni | 2.50E + 04 |
| Si | 2.99E + 04 |
| Ag | 3.25E + 04 |
| V | 4.30E + 04 |
| Ta | 8.80E + 04 |
| Fe | 1.06E + 05 |
| F | 1.20E + 05 |
| Cu | 2.55E + 07 |
| Pt | 7.13E + 07 |

IV Characteristic of TFT

A normally-off state was also observed in the transistor of Example 4.

As described hereinabove, from the standpoint of easiness of manufacturing a field effect transistor, it is preferred that the oxide semiconductor material X be an oxide further containing a doping element. Thus, when a doping element is used, the controllability of a carrier concentration in the oxide semiconductor material X is increased.

**Industrial Applicability**

With the oxide semiconductor material in accordance with the present invention, it is possible to provide an oxide semiconductor material that has a low electron carrier concentration capable of standing practical use and is suitable for electronic devices such as a field effect transistor. The present invention also provides a method by which the oxide semiconductor material can be easily manufactured.

## Claims

1. An oxide semiconductor material comprising Zn, Sn, and O, containing no In, and having an electron carrier concentration higher than $1 \times 10^{15}/cm^3$ and less than $1 \times 10^{18}/cm^3$, wherein the oxide semiconductor material further comprises a dopant which is at least one member selected from the group consisting of Zr, Mo, Cr, W, Nb, Hf, Ni, Ag, V, Ta, Fe, Cu, Pt, Si, and F.

2. The oxide semiconductor material according to claim 1, wherein the oxide semiconductor material is amorphous.

3. An electronic device comprising a semiconductor layer formed of the oxide semiconductor material according to either of claims 1 or 2 and an electrode provided on the semiconductor layer.

4. A field effect transistor comprising:

   a semiconductor layer formed of the oxide semiconductor material according to either of claims 1 or 2;
   a source electrode and a drain electrode which are arranged in separation from each other on the semiconductor layer; and
   a gate electrode placed at a position where the gate electrode can apply a bias potential to a region of the semiconductor layer positioned between the source electrode and the drain electrode.

## Patentansprüche

1. Oxid-Halbleitermaterial umfassend Zn, Sn und O, welches kein In enthält und welches eine Elektronenträgerkonzentration von mehr als $1 \times 10^{15}$ /cm$^3$ und weniger als $1 \times 10^{18}$ /cm$^3$ aufweist, wobei das Oxid-Halbleitermaterial ferner ein Dotierungsmittel umfaßt, weiches wenigstens ein Element ist, das aus der aus Zr, Mo, Cr, W, Nb, Hf, Ni, Ag, V, Ta, Fe, Cu, Pt, Si und F bestehenden Gruppe ausgewählt ist.

2. Oxid-Halbleitermaterial nach Anspruch 1, wobei das Oxid-Halbleitermaterial amorph ist.

3. Elektronische Vorrichtung umfassend eine Halbleiterschicht, die aus dem Oxim-Halbleitermaterial nach einem der Ansprüche 1 oder 2 gebildet ist, und eine Elektrode, die auf der Halbleiterschicht vorgesehen ist.

4. Feldeffekttransistor umfassend:

   eine Halbleiterschicht, die aus dem Oxid-Halbleitermaterial nach einem der Ansprüche 1 oder 2 gebildet ist,
   eine Sourceelektrode und eine Drainelektrode, welche getrennt voneinander auf der Halbleiterschicht angeordnet sind, und
   eine Gateelektrode, die an einer Stelle angeordnet ist, wo die Gatelektrode ein Vorspannungspotential an einem zwischen der Sourceelektrode und der Drainelektrode angeordneten Bereich der Halbleiterschicht anlegen kann.

## Revendications

1. Matériau semi-conducteur oxyde comprenant Zn, Sn et O, ne contenant pas In, et ayant une concentration de porteurs d'électrons supérieure à $1 \times 10^{15}/cm^3$ et inférieure à $1 \times 10^{18}/cm^3$, où le matériau semi-conducteur oxyde comprend en outre un dopant qui est au moins un membre choisi dans le groupe consistant en Zr, Mo, Cr, W, Nb, Hf, Ni, Ag, V, Ta, Fe, Cu, Pt, Si et F.

2. Matériau semi-conducteur oxyde selon la revendication 1, où le matériau semi-conducteur oxyde est amorphe.

3. Dispositif électronique comprenant une couche de semi-conducteur formée du matériau semi-conducteur oxyde selon l'une quelconque des revendications 1 et 2 et une électrode disposée sur la couche de semi-conducteur.

4. Transistor à effet de champ comprenant :

   une couche de semi-conducteur formée du matériau semi-conducteur oxyde selon l'une quelconque des revendications 1 et 2 ;
   une électrode de source et une électrode de drain qui sont agencées séparément l'une de l'autre sur la couche de semi-conducteur ; et
   une électrode de grille placée à une position où l'électrode de grille peut appliquer un potentiel de polarisation à une région de la couche de semi-conducteur positionnée entre l'électrode de source et l'électrode de drain.

*Fig.1*

10

1S          1D

II          II

L

2

*Fig.2*

# Fig.3

EP 2 219 225 B1

# Fig.4

EP 2 219 225 B1

# Fig.5

# Fig.6

## Fig.7

EP 2 219 225 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003298062 A
- JP 2000044236 A
- JP 2006165532 A

- JP 2006528843 PCT
- WO 2007058232 A